Europäisches Patentamt

European Patent Office

Office européen des brevets

(11) Veröffentlichungsnummer: **0 103 654**
**B1**

(12) **EUROPÄISCHE PATENTSCHRIFT**

(19)

(45) Veröffentlichungstag der Patentschrift:
20.05.87

(21) Anmeldenummer: **82108757.4**

(22) Anmeldetag: **22.09.82**

(51) Int. Cl.⁴: **G 11 C 29/00**

(54) Elektrisch programmierbare Speichermatrix.

(43) Veröffentlichungstag der Anmeldung:
28.03.84 Patentblatt 84/13

(45) Bekanntmachung des Hinweises auf die Patenterteilung:
20.05.87 Patentblatt 87/21

(84) Benannte Vertragsstaaten:
DE FR GB IT NL

(56) Entgegenhaltungen:
EP-A-0 055 594

DIGEST OF PAPERS 1980 TEST CONFERENCE, 11.-13. November 1980, Papier 3.1, Seiten 45-49, IEEE Computer Society, New York, USA, M. HENTZ: "An advanced pattern generator for memory testing"

(73) Patentinhaber: **Deutsche ITT Industries GmbH, Hans- Bunte- Strasse 19 Postfach 840, D-7800 Freiburg (DE)**
(84) Benannte Vertragsstaaten: **DE**

(73) Patentinhaber: **ITT INDUSTRIES INC., 320 Park Avenue, New York, NY 10022 (US)**
(84) Benannte Vertragsstaaten: **FR GB IT NL**

(72) Erfinder: **Giebel, Burkhard, Dipl.- Ing., Berliner Strasse 25/2, D-7809 Denzlingen (DE)**

(74) Vertreter: **Morstadt, Volker, Dipl.- Ing., c/o Deutsche ITT Industries GmbH Patent/Lizenzabteilung Postfach 840 Hans- Bunte-Strasse 19, D-7800 Freiburg/Brsg. (DE)**

## Beschreibung

Bei Speicherzellen für Matrixspeicher des Typs mit potentialmäßig schwebendem Speichergate (floating gate), wie sie beispielsweise aus der Zeitschrift "Electronics" vom 28. 2. 1880, Seiten 113 bis 117, bekannt sind, können fehlerhafte Isolierschichten, beispielsweise zwischen Steuergate und Speichergate oder auch zwischen den Zonen und dem Speichergate, zu unbeabsichtigten Umprogrammierungen aufgrund von überhöhten Leckströmen Anlaß geben. Die Speicherzellen müssen daher nach der Herstellung einem Test unterworfen werden, wie es aus der DE-OS 30-30 852 und den veröffentlichten Unterlagen zur Anmeldung WO 81/00154 bekannt ist. Diese Druckschriften beschäftigen sich mit Testverfahren für eine elektrisch programmierbare Speichermatrix mit n Zeilenwahlleitungen, über welche je m Speicherzellen ansteuerbar sind und die an je einem von n Ausgängen eines Zeilendekoders angeschlossen sind, welcher a Eingangsanschlußpaare gemäß der Beziehung n = 2$^a$ aufweist. In den Zeilendekoder werden je nach Betriebsart ein Grundpotential Vo in der Nähe des Nullpotentials, ein Versorgungspotential Vcc von ca. 5 V und ein Programmierungspotential Vp von beispielsweise 25 eingespeist. Bei den bekannten programmierbaren Speichermatrizen, mit deren Tests sich die Erfindung beschäftigt, liegt im Normalbetrieb (Schreiben, Löschen, Lesen) an dem einen Anschluß jedes der a Eingangsanschlußpaare des Zeilendekoders jeweils ein erstes Eingangssignal und am anderen Anschluß ein zum ersten komplementäres zweites Eingangssignal an.

Zur Durchführung eines Testbetriebes ist an jedem der a die Eingangsanschlußpaare speisenden Adressverstärker eine zusätzliche Aktivierungsklemme vorgesehen, an die zur Aktivierung das Aktivierungssignal $\overline{PD}$ = H, zur Passivierung das Signal $\overline{PD}$ = L anlegbar ist. Im ersteren Falle sind alle Zeilenwahlleitungen auf einen für die Programmierung erforderlichen hohen Pegel schaltbar.

Zur Durchführung eines Testbetriebes ist nach den Unterlagen der Anmeldung WO 81/00154 vorgesehen, über eine gewisse Zeit gleichzeitig zwischen Steuergate und Source jedes Speichertransistors eine Testspannung anzulegen. Bei dem Testverfahren der DE-OS 30 30 852 ist vorgesehen, mittels der Zusatzschaltung die Adressverstärker zu passivieren, so daß alle Zeilenauswahlleitungen gleichzeitig auf einem für die Programmierung erforderlichen Pegel schaltbar sind, in den Dekoder die Programmierspannung einzuspeisen und schließlich in einem auf den Test folgenden Lesevorgang zu prüfen, ob in den Speicherzellen eine Umprogrammierung aufgrund eines Leckstrommechanismus stattgefunden hat.

Mittels der bekannten Zusatzschaltungen wird also ein Testbetrieb ermöglicht, bei dem sämtliche Speicherzellen einem Programmiervorgang bzw. gleichzeitig einer Spannungsbelastung unterworfen werden können, dessen Auswirkungen in einem folgenden Lesebetrieb gemessen werden können. Dabei wird davon ausgegangen, daß die Einzelprüfung der Speicherzellen auf Leckstellen aufgrund der untragbar langen Prüfzeit praktisch nicht in Frage kommt.

Aus der EP-A-0 055 594 ist eine von der Erfindung betroffene elektrisch programmierbare Speichermatrix mit zusätzlichen Aktivierungsschaltungen gemäß den Oberbegriff des Anspruchs bekannt.

Mittels der aktivierenden Zusatzschaltungen des bekannten Matrixspeichers ist aber das Testen von nebeneinanderliegenden Zellen mit unterschiedlicher Programmierung auf eine gegenseitige Beeinflussung, wozu besonders eine Schachbrettmusterprogrammierung geeignet ist, nicht möglich.

Aufgabe der Erfindung ist daher die Angabe eines Matrixspeichers mit einer einfachen Zusatzschaltung, die bei geringem Kristallflächenaufwand in den Matrixspeicher integrierbar ist und die es ermöglicht, daß ohne wesentliche Erhöhung der Prüfzeit die wechselseitige Beeinflussung unterschiedlich Programmierter benachbarter Zellen, insbesondere mittels einer Schachbrettmusterprogrammierung, prüfbar ist.

Aus "Digest of Papers 1980 Test Conference 11./13.November 1980" Papier 3.1, Seiten 45 bis 49, ist eine solche Schachbrettmusterprogrammierung eines Matrixspeichers bekannt, die von außen mittels eines aufwendigen Prüfmustergenerators erfolgt, der aufgrund seines Schaltungsaufwandes und der dadurch bei einer Integrierung bedingten Kristallflächenaufwands nicht mit der Speichermatrix integriert werden kann.

Die vorstehend genannte Aufgabe wird bei der elektrisch Programmierbaren Speichermatrix mit den im Oberbegriff des Anspruchs 1 angegebenen Merkmalen erfindungsgemäß durch die im kennzeichnenden Teil genannte Ausbildung gelöst.

Die Erfindung wird im folgenden anhand der Zeichnung erläutert,

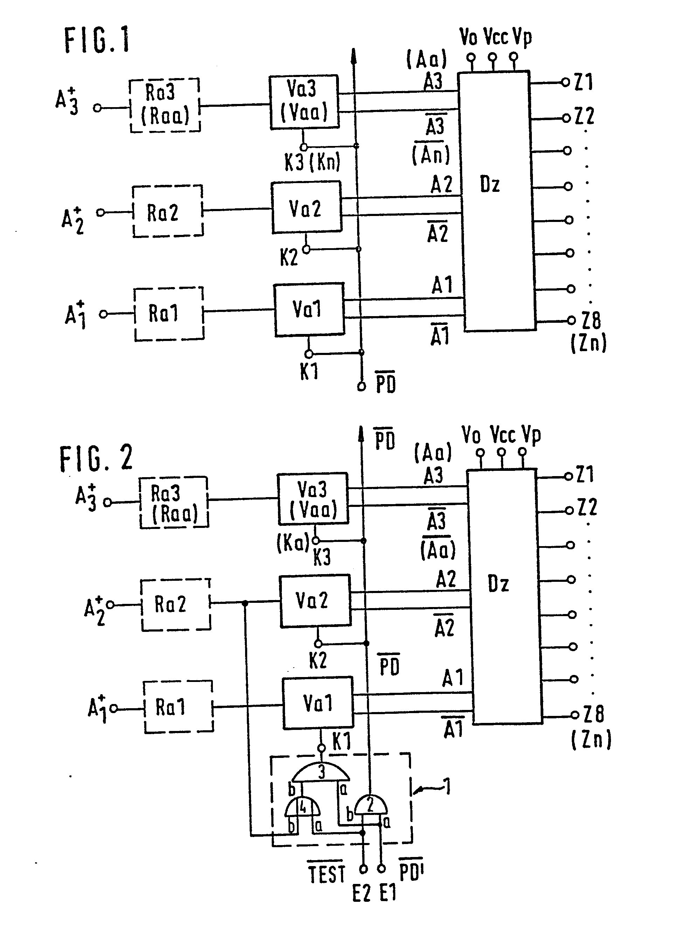

deren Fig. 1 das Blockschaltbild des bekannten Matrixspeichers betrifft, von dem die Erfindung ausgeht und

deren Fig. 2 als Blockschaltbild den von der Erfindung betroffenen Teil der Speichermatrix mit der Zusatzschaltung zur Durchführung einer Schachbrettmuster-Programmierung zeigt.

Fig. 1 zeigt den Zeilendekoder Dz, in Form eines einfachen NOR-Gatters, dessen Schaltung sich von der des als Spaltendekoder bezeichneten Dekoderschaltung der Fig. 7 der eingangs genannten Unterlagen zur Patentanmeldung WO 81/00154 dadurch unterscheidet, daß der Transistor T15 durch einen Kurzschluß ersetzt ist. Der Dekoder weist n, im Beispiel der Fig. 1 der anliegenden Zeichnung acht Ausgänge Z1 bis Z8 auf, an die die entsprechende Anzahl von Zeilenwahlleitungen angeschlossen werden. Bei der aktiven Lese-, Schreib- und Lösch-Betriebsart liegen alle Ausgänge des Zeilendekoders Dz bis auf einen ausgewählten Ausgang auf ein Potential Vo entsprechend einem "Tiefpegel".

Die Dekoder der von der Erfindung betroffenen Matrixspeicher werden von a Adressenverstärker Va1 bis Vaa entsprechend der Beziehung $n = 2^a$ angesteuert. Diese liefern Paare von komplementären Ausgangssignalen, wie die Figuren veranschaulichen. Die Adressverstärker Va1 bis Vaa selbst können von je einem von in den Figuren gestrichelt gezeichneten a Adreßregistern Ra1 bis Raa angesteuert werden, in welche je ein Bit $A+_1$, $A+_2$, $A+_3$ der Speicheradresse eingegeben wird. Jeder der Adressverstärker Va1... Vaa weist eine Aktivierungsklemme K1...Ka auf, an die das Aktivierungssignal $\bar{P}\bar{D}$ anlegbar ist. Die Adressverstärker sind in bekannter Weise derartig ausgelegt, daß diese aktiviert werden, d. h. komplementäre Steuersignale abgeben, sobald dieses Aktivierungssignal $\bar{P}\bar{D}$ auf dem Hochpegel H liegt. Das Aktivierungssignal unterscheidet gleichzeitig einen inaktiven Stromsparbetrieb der gesamten Speicherschaltung von der aktiven Betriebsart.

Bei der "inaktiven" Betriebsart liegen dagegen sämtliche Ausgänge der Adressverstärker auf einem Tiefpotential Vo. Die inaktive Betriebsart zeichnet sich demnach dadurch aus, daß sämtliche Eingangsanschlüsse des Zeilendekoders Dz, welche die Ausgangssignale A1, Ā1;...;Aa, Āā der Adreßverstärker Va1...Vaa erhalten, auf einem Tiefpegel liegen, was einen Hochpegel sämtlicher Ausgangssignale des Dekoders zur Folge hat.

Um die angestrebte Schachbrettmusterprogrammierung zu erhalten müssen Zeilen mit geraden Ordnungsziffern (Z2, Z4,...) und Zeilen mit ungeraden (Z1, Z3,...) im Bitmuster unterschiedlich programmiert werden; innerhalb dieser Guppen ist jedoch das Bitmuster entlang der Zeile gleich. Es liegt daher nahe, den Zeilendekoder Dz so zu aktivieren, daß wahlweise alle geraden oder alle ungeraden Zeilen angewählt werden. Diese Betriebsart sollte im Normalbetrieb nicht anwählbar sein, sondern nur in einer Testbetriebsart.

Erfindungsgemäß werden die Adressverstärker für die Testbetriebsart in ihrer Funktion durch eine logische Schaltung 1 umgeschaltet. Diese logische Schaltung 1 zeichnet sich dadurch aus, daß der erste Eingang E1 der Zusatzschaltung 1 mit dem ersten Eingang a eines ersten AND-Gatters 2 und dem ersten Eingang a eines zweiten AND-Gatters 3 verbunden ist. Ferner liegt der zweite Eingang E2 der Zusatzschaltung 1 am zweiten Eingang b des ersten AND-Gatters 2 und am ersten Eingang a eines OR-Gatters 4, dessen Ausgang mit dem zweiten Eingang b des zweiten AND-Gatters 3 verbunden ist. Der Ausgang des zweiten AND-Gatters 3 liegt prinzipiell am Aktivierungsanschluß eines der a Adressverstärker, während an den Aktivierungsanschlüssen der übrigen Adressverstärker das Ausgangssignal des ersten AND-Gatters 2 angelegt wird und der Eingang eines des übrigen Adressverstärker mit dem zweiten Eingang b des OR-Gatters 4 verbunden ist. Am Ausführungsbeispiel der Fig. 2 mit einem 8-Bit-Zeilendekoder liegt der zweite Eingang b des OR-Gatters 4 am Eingang des Adressverstärkers Va2. In diesem Fall ist ein Zeilenauswahlmuster mit der Periode 2 (gerade/ungerade) erzielbar.

Ist ein Spalten- oder auch Blockdekoder zur Unterscheidung mehrerer Speicherbytes entlang einer Zeile vorgesehen, so kann analog zu der Auslegung des Zeilendekoders entsprechend der Erfindung auch bei diesen Dekodern eine Auswahlmöglichkeit gerade/ungerade vorgesehen werden. Im allgemeinen ist es jedoch zur Erzielung eines Schachbrettmusters ausreichend, eine Auswahlmöglichkeit aller Spalten bzw. Blöcke gleichzeitig vorzusehen durch Ansteuerung mit Adreßsignalen anlog zu denen der Adressverstärker Va2, Va3. Das Bitmuster wird dann nur noch von den Potentialen der Datenleitungen, also von den Speichereingangsdaten, bestimmt.

In einer elektrisch programmierbaren Speichermatrix nach der Erfindung erfolgt somit bei Anlegen des Signals TEST gleich L an E2 und folgenden Programmiervorgang eine gleichzeitige Programmierung mehrerer Speicherzeilen mit demselben Bitmuster entlang jeder Zeile, wenn die betreffenden Ausgänge des Zeilendekoders Dz das Programmierpotential Vp führen. Die gleichzeitige Auswahl mehrerer Dekoder wird dadurch ereicht, daß alle die betreffenden Dekoder ansteuernden Adressignale an den Ausgängen der Adressverstärker auf das Tiefpegelpotential Vo gelegt werden. Ein solches an alle Eingänge aller Dekoder angelegtes Tiefpegelsignal Vo ist aber bereits für die inaktive Betriebsart vorgesehen. Nach der Erfindung wird derselbe Zustand, wahlweise beschränkt auf einen Teil der Adressverstärker, auch für den Test-Programmierbetrieb verfügbar gemacht.

Im Hinblick auf die in Fig. 2 mit den für die Erfindung wesentlichen Schaltungskomponenten dargestellte Speichermatrix kann zum Verständnis der Funktionsweise offensichtlich zwischen zwei Betriebsweisen unterschieden werden:

1. Bei "nicht aktiviertem Testbetrieb" ($\bar{TEST}$ = H) beeinflußt das $\bar{P}\bar{D}$-Signal in allen Adressverstärkern deren Ausgangssignale An bzw. Āñ (PD = H: An, Āñ wählbar); $\bar{P}\bar{D}$ = L: An = Āñ = L)

2. Bei aktiviertem Testbetrieb ($\bar{TEST}$ = L) kann das $\bar{P}\bar{D}$-Signal die Adressverstärker Va3 und Va2 nicht mehr aktivieren. (An = Āñ = L). Der Adressverstärker Va1 wird jedoch aktiviert, wenn $A_2$ auf dem Hochpegel liegt.

Beim Testbetrieb d.h. $\bar{TEST}$ = L und für $\bar{P}\bar{D}$ = H

entscheidet daher A2 zwischen dem inaktiven und aktiven Zustand des Adressverstärkers Val. In letzerem Fall ist entsprechend dem Pegel von A1+ entweder A1 oder Ā1 auf Hochpegel und damit entweder die 50% geraden oder die 50% ungeraden Zeilenwahlleitungen des Zeilendekoders gesperrt.

Das programmierbare Bitmuster entlang jeder ausgewählten Zeile ist gleich und entspricht den über die Datenleitungen und evtl. vorgesehenen Spalten/Blockdekoder angelegten Daten. So können z.B. mit einem Programmiervorgang 50% aller Zeilen, d.h. 50% aller Bitstellen programmiert werden.

### Patentansprüche

1. Elektrisch programmierbare Speichermatrix mit n Zeilenwahlleitungen (Z1...Zn), über welche je m Speicherzellen ansteuerbar sind und die an je einem von n Ausgängen eines Zeilendekoders (Dz) angeschlossen sind, welcher a Eingangsanschlußpaare gemäß der Beziehung n = 2$^a$ aufweist und welcher je nach Betriebsart ein Grundpotential (Vo), ein Versorgungspotential (Vcc) oder ein Programmierpotential (Vp) als Ausgangssignal liefert, wobei
- in der aktiven Betriebsart jeder einzelne von a Adreßverstärkern (Va1, Va2, Va3; Vaa) mittels eines an seine Aktivierungsklemme (K1, K2, K3; Ka) angelegten Signals P̄D̄ = H über eine zusätzliche Aktivierungsschaltung aktiviert werden kann, wodurch an dem einen Anschluß des Eingangsanschlußpaares das eine Ausgangssignal (A1, A2, A3, Aa) und am anderen Anschluß das dazu komplementäre Ausgangssignal (BCA1,... Āā) anliegt und
- in der inaktiven Betriebsart jeder einzelne der a Adreßverstärker (Va1...Vaa) mittels eines an seine Aktivierungsklemme über die Aktivierungsschaltung angelegten Signals (P̄D̄ = L) inaktiviert werden kann, wodurch alle Adreßverstärkerausgänge (Z1...Z8; Zn) auf einen tiefen Pegel schaltbar sind,
dadurch gekennzeichnet, daß zur Durchführung eines Testbetriebes
- eine Zusatzschaltung (1) vorgesehen ist, an deren ersten Eingang (E1) das Aktivierungssignal (P̄D̄) und am zweiten Eingang (E2) das Testsignal (T̄Ē S̄T̄) anliegen, wobei durch T̄Ē S̄T̄ = H der Testbetrieb blockiert ist,
- der erste Eingang (E1) der Zusatzschaltung (1) mit dem ersten Eingang (a) eines ersten AND-Gatters (2) und dem ersten Eingang (a) eines zweiten AND-Gatters (3) verbunden ist,
- der zweite Eingang (E2) der Zusatzschaltung (1) am zweiten Eingang (b) des ersten AND-Gatters (2) und am ersten Eingang (a) eines OR-Gatters (4) liegt, dessen Ausgang mit dem zweitem Eingang (b) des zweiten AND-Gatters (3) verbunden ist,
- der Ausgang des zweiten AND-Gatters (3) an der Aktivierungsklemme (K1, K2, K3; Ka) eines der a Adressverstärker (Va1, Va2, Va3; Vaa) liegt, während an den Aktivierungsklemmen der übrigen Adressverstärker das Ausgangssignal des ersten AND-Gatters (2) angelegt ist und der Eingang eines der übrigen Adressverstärker mit dem zweiten Eingang (b) des OR-Gatters (4) verbunden ist.

2. Elektrisch programmierbare Speichermatrix nach Anspruch 1, dadurch gekennzeichnet, daß
- die Aktivierungsklemme eines Adressverstärkers eines Spalten- bzw. Blockdekoders der Speichermatrix mit dem Ausgang des zweiten AND-Gatter (3) und die Aktivierungsklemmen der übrigen Adressverstärker dieser Dekoder mit dem Ausgang des ersten AND-Gatters (2) verbunden sind.

3. Elektrisch programmierbare Speichermatrix nach Anspruch 1, dadurch gekennzeichnet, daß
- die Aktivierungsklemmen aller Adressverstärker eines Spalten- bzw. Blockdekoders der Speichermatrix mit dem Ausgang des ersten AND-Gatters (2) verbunden sind.

### Claims

1. Electrically programmable memory matrix comprising n row selecting lines (Z1 through Zn), via which each time m memory cells are controllable, and which are connected to each time one of n outputs of a row decode (Dz) comprising a input terminal pairs according to the relationship n = 2$^a$ and which, quite depending on the mode of operation, supplies a around potential (Vo), a supply potential (Vcc) or a programming potential (Vp) output signal, wherein
- during the active mode of operation each one of the a address amplifiers (Va1, Va2, Va3; Vaa) can be activated by means of a signal P̄D̄ = H applied to its activating terminal (K1, K2, K3; Ka) via an additional activating circuit whereby to the one terminal of the input terminal pair there is applied the one output signal (A1, A2, A3, Aa) and to the other terminal there is applied the output signal (Ā1,....Āā) which is complementary thereto, and
- during the inactive mode of operation, each of said a address amplifiers (Va1, Va2, Va3; Vaa), by means of a signal (P̄D̄ = L) applied to one activating terminal (K1, K2, K3; Ka) via said activating circuit, can be inactivated, so that all adress amplifier outputs (Z1 through Z8; Zn) are capable of being switched to a low level,
characterized in
that for carrying out a test operation
- there is provided an additional circuit (1) to the first input (EI) of which there is applied the activating signal (P̄D̄), and to the second input (E2) of which there is applied the test signal (T̄Ē S̄T̄) with the test operation being blocked by

TEST = H,

- the first input (E1) of said additional circuit (1) is connected to the first input (a) of a first AND gate (2) and to the first input (a) of a second AND gate (3),
- the second input (E2) of said additional circuit (1) is connected to the second input (b) of the first AND-gate (2) and to the first input (a) of an OR-gate (4) whose output is connected to the second input (b) of said second AND-gate (3),
- the output of said second AND gate (3) is connected to the activating terminal (k1, K2, K3; Ka) of one of said a address amplifiers (Va1, Va2, Va3; Vaa) whereas to the activating terminals of the remaining address amplifiers there is applied the output signal of said first AND gate (2), with the input of one of the remaining address amplifiers being connected to the second input (b) of said OR gate (4).

2. An electrically programmable memory matrix as claimed in claim 1, characterized in that the activating terminal of one address amplifier of one column or block decoder of the memory matrix is connected to the output of second AND gate (3), with the activating terminals of the remaining address amplifiers of these decoders being connected to the output of said first AND gate (2).

3. An electrically programmable memory matrix as claimed in claim 1, characterized in that

- the activating terminals of all address amplifiers of a column or block decoder of said memory matrix are connected to the output of said first AND gate (2).

## Revendications

1. Matrice de mémoire électriquement programmable comprenant n lignes de sélection de rangée (Z1 à Zn) au moyen de chacune desquelles m cellules de mémoire peuvent être commandées et qui sont respectivement connectées aux n sorties d'un décodeur de rangée (Dz) comportant a paires de bornes d'entrée, selon la relation n = 2 et fournissant un signal de sortie ayant, selon le mode de fonctionnement, un potentiel de masse Vo, un potentiel d'alimentation (Vcc) ou un potentiel de programmation (Vp), dans lequel:
- durant le mode de fonctionnement actif, chacun des a amplificateurs d'adresse (Va1, Va2, Va3; Vaa), peut être rendu actif en réponse à un signal d'activation PD = H d'un circuit d'activation additionnel, appliqué à sa borne d'activation (K1, K2, K3; Ka), en sorte qu'à une des bornes des paires de bornes d'entrée soit appliqué un premier signal de sortie (A1, A2, A3; Aa), tandis qu'à l'autre borne est appliqué le signal de sortie complémentaire du précédent (A1, A2, A3; Aa), et
- durant le mode de fonctionnement inactif, chacun des a amplificateurs d'adresse (Va1, Va2, Va3, Vaa), peut être rendu inactif en réponse à un signal d'activation PPD = L du circuit d'activation, appliqué à sa borne d'activation (K1, K2, K3; Ka), ce qui permet de commuter toutes les sorties d'amplificateurs d'adresse (Z1 à Z8; Zn), caractérisé en ce que, pour les besoins d'une opération de test:
- il est prévu un circuit additionnel (1) à la première entrée (E1) duquel est appliqué le signal d'activation (PD) et à la seconde entrée (E2) duquel est appliqué le signal de test (TEST), de sorte que l'opération de test.est bloquée lorsque TEST = H,
- la première entrée (E1) du circuit additionnel (1) est connectée à la première entrée (a) d'une première porte ET (2) et à la première entrée (a) d'une seconde porte ET (3),
- la deuxième entrée (E2) est connectée à la deuxième entrée (b) de la première porte ET (2) et à la première entrée (a) d'une porte DU (4) dont la sortie est connectée à la seconde entrée (b) de la deuxième porte ET (3),
- la sortie de la deuxième porte ET (3) est connectée à la borne d'activation (K1, K2, K3: Ka) de l'un des a amplificateurs d'adresse (Va1, Va2, Va3; Vaa), alors que les bornes d'activation des amplificateurs d'adresse restants reçoivent le signal de sortie de la première porte ET (2), l'entrée de l'un des amplificateurs d'adresse restants étant connectée à la deuxième entrée (b) de la porte OU (4).

2. Matrice de mémoire électriquement programmable selon la revendication 1, caractérisée en ce que:
- la borne d'activation d'un amplificateur d'adresse d'un décodeur de bloc ou de colonne de la matrice de mémoire est connectée à la sortie de la deuxième porte ET (3), les bornes d'activation des autres amplificateurs d'adresse de ces décodeurs étant connectées à la sortie de ladite première porte ET (2).

3. Matrice de mémoire électriquement programmable selon la revendication 1, caractérisée en ce que:
- les bornes d'activation de tous les amplificateurs d'adresse d'un décodeur de bloc ou de colonne de ladite matrice de mémoire sont connectées à la sortie de ladite première porte ET (2).

# FIG. 1

# FIG. 2